Europäisches Patentamt

European Patent Office

Office européen des brevets

(11) Veröffentlichungsnummer: **0 329 917 B1**

# (12) EUROPÄISCHE PATENTSCHRIFT

(45) Veröffentlichungstag der Patentschrift: **19.11.92**

(21) Anmeldenummer: **88730250.3**

(22) Anmeldetag: **12.11.88**

(51) Int. Cl.⁵: **H01R 43/01**

(54) Werkzeug zum Anschliessen von Kabeladern.

(30) Priorität: **06.02.88 DE 3803969**

(43) Veröffentlichungstag der Anmeldung:
**30.08.89 Patentblatt 89/35**

(45) Bekanntmachung des Hinweises auf die
Patenterteilung:
**19.11.92 Patentblatt 92/47**

(84) Benannte Vertragsstaaten:
**AT BE CH DE ES FR GB GR IT LI LU NL SE**

(56) Entgegenhaltungen:
**EP-A- 0 040 307**
**EP-A- 0 214 619**
**GB-A- 1 288 342**

(73) Patentinhaber: **KRONE Aktiengesellschaft**
**Beeskowdamm 3-11**
**W-1000 Berlin 37(DE)**

(72) Erfinder: **Herfort, Hermann**
**Achenseeweg 75**
**W-1000 Berlin 45(DE)**
Erfinder: **Bramkamp, Wilhelm**
**Pintschallee 17**
**W-1000 Berlin 47(DE)**
Erfinder: **Radelow, Wolfgang**
**Stubenrauchstrasse 26**
**W-1000 Berlin 47(DE)**
Erfinder: **Hegner, Gunter**
**Moränenweg 22**
**W-1000 Berlin 27(DE)**

EP 0 329 917 B1

## Beschreibung

Die Erfindung bezieht sich auf ein Werkzeug zum Anschließen von Kabeladern, insbesondere von Fernmeldekabeln, an Schneidklemmkontakten gemäß dem Oberbegriff des Anspruches 1.

Aus der EP-PS 0040307 ist ein Werkzeug zum elektrischen Anschließen von isolierten Leiterdrähten vorbekannt. Dieses Werkzeug besteht aus einem zweiteiligen Handgriff, in dem ein Stößel in einem Schieber längsverschiebbar angeordnet ist. Am vorderen Ende des Stößels ist am Stößelkopf ein aus zwei Scherenschenkeln bestehender Drahtschneider angeordnet. Ein Scherenschenkel ist schwenkbar und besitzt am hinteren Ende einen schrägen Längsschlitz, in dem ein im Handgriff befestigter Stift geführt ist. Eine Längsverschiebung des Stößels führt somit zu einer Schwenkbewegung der Scherenschenkel. Zum Eindrücken einer isolierten Kabelader in einen in einer Anschlußleiste angeordneten Schneidklemmkontakt wird der Stößelkopf zuerst auf die Anschlußleiste aufgesetzt. Von Hand wird der Handgriff in Richtung Anschlußleiste gedrückt, bis die Kabelader in den Kontaktschlitz des Schneidklemmkontaktes eingedrückt ist. Die auf den Handgriff ausgeübte Vorschubkraft bewirkt eine Relativbewegung zwischen dem Stößel und dem Handgriff sowie zwischen dem Scherenschenkel des Drahtschneiders und dem am Handgriff befestigten Stift, welcher in den schrägen Längsschlitz hineingleitet und dabei den beweglichen Scherenschenkel derart verschwenkt, daß eine an seinem vorderen Ende ausgebildete Schneide die Kabelader abschneidet.

Dieser Anschaltvorgang besitzt den Nachteil, daß der Abschneidevorgang bei einer Fehlbedienung bereits ausgeführt wird, bevor der Draht in der Endstellung in den Klemmschlitz des Schneidklemmkontaktes eingeführt ist. So entsteht durch die kürzere Kabellänge eine unzureichende Führung der Kabelader, wodurch eine unvollkommene Kontaktverbindung zwischen dem leitenden Kern der isolierten Kabelader und dem Schneidklemmkontakt entsteht. Darüber hinaus wird bei dicken Kabeladern der Schlagmechanismus ausgelöst, bevor die Kabelader vollständig in den Kontaktschlitz des Schneidklemmkontaktes eingedrückt ist. Hierdurch entsteht eine unvollkommene Kontaktverbindung.

Der Erfindung liegt von daher die Aufgabe zugrunde, ein Werkzeug zum Anschließen von Kabeladern der gattungsgemäßen Art zu schaffen, bei dem das Abschneiden des Kabelendes und das Auslösen des Schlagmechanismus erst nach dem Eindrücken der Kabelader in den Kontaktschlitz erfolgt und somit eine einwandfreie Kontaktverbindung gewährleistet ist.

Die Lösung dieser Aufgabe ergibt sich aus den kennzeichnenden Merkmalen des Anspruches 1. Erfindungsgemäß gibt der am Stößelkopf angeordnete und mit einem Rastgesperre verbundene Fühler die Längsverschiebung des Stößels im Werkzeuggehäuse und damit den Abschneidevorgang erst dann frei, wenn die anzuschließende Kabelader vollständig die Endstellung im Kontaktschlitz des Schneidklemmkontaktes erreicht hat und eine einwandfreie Kontaktverbindung hergestellt ist. Somit ist gewährleistet, daß das Kabeladerende erst nach der Kontaktierung abgeschnitten wird.

Weitere vorteilhafte Ausgestaltungen der Erfindung ergeben sich aus den Unteransprüchen. Hingewiesen wird insbesondere auf die Ausführung gemäß Anspruch 4, wonach das Rastgesperre unabhängig vom Fühler über eine Entriegelungsvorrichtung entriegelt werden kann. Eine derartige Entriegelung ist insbesondere dann notwendig, wenn zwei Kabeladern in einem Kontaktschlitz eines Schneidklemmkontaktes angeschlossen werden.

Die Erfindung ist nachfolgend anhand eines in den Zeichnungen dargestellten Ausführungsbeispieles näher erläutert.

Es zeigt:

Fig. 1      eine Seitenansicht des Werkzeuges teilweise in einer Schnittdarstellung,

Fig. 2      die Vorderansicht teilweise in einer Schnittdarstellung,

Fig. 3      das auf eine Anschlußleiste aufgesetzte Werkzeug in der Seitenansicht, und

Fig. 4      den Stößelkopf des Werkzeuges ohne Abschneider, in der Vorderansicht gemäß Fig. 2.

Das Werkzeug 1 besteht aus einem aus zwei Kunststoffhalbschalen 14,15 gebildeten Werkzeuggehäuse 12, welches einen Handgriff 16 bildet. Die beiden Gehäusehalbschalen 14,15 sind gegeneinander über Schrauben 17 verbunden. In dem an einer Stirnseite 32 mit einer Öffnung 33 versehenen Handgriff 16 sind ein Stößel 2 und ein Schieber 19 längsverschiebbar angeordnet.

Darüber hinaus sind ein Drehknopf 21 als Feststeller im Handgriff 16 und am vorderen Ende des Stößels 2 am Stößelkopf 5 ein Abschneider 29 vorgesehen. Ein solches Werkzeug mit Stößel, Schieber, Abschneider und Drehknopf ist in der EP 0040307 näher beschrieben, auf welche ausdrücklich Bezug genommen wird. Im Unterschied zum bekannten Stößel weist der Stößel 2 des Werkzeuges 1 ein Rastgesperre 3 auf, das zwischen zwei Seitenwänden 24,25 des Stößels 2 angeordnet ist.

Das Rastgesperre 3 besteht aus einer Klinke 10 und einer Schenkelfeder 22. Die Klinke 10 weist eine Querbohrung 23 auf. In diese Querbohrung 23 der Klinke 10 und in zwei Querbohrungen der Seitenwände 24,25 des Stößels 2 ist eine Achse 26 eingesteckt, so daß die Klinke 10 drehbar im Stößel 2 angeordnet ist, wie insbesondere die Fig. 4 zeigt. Auf der Achse 26 ist die Schenkelfeder 22 aufgenommen, deren einer Schenkel 27 in einer weiteren Bohrung 37 der Klinke 10 eingesteckt ist und deren anderer Schenkel 28 sich an einer Querwand 30 des Stößels 2 abstützt. Die Klinke 10 nimmt somit federbelastet eine definierte Position ein, bei der der hakenförmig ausgebildete Teil der Klinke 10 hinter die Stirnwand 34 der Gehäuseschale 15 greift. In einer Seitenwand 31 der Klinke 10 ist eine Fühlerstange 9 eingehakt, die bis zum vorderen Teil des Stößelkopfes 5 verlängert und dort um 90 ° umgebogen als Fühler 6 ausgebildet ist. Der Fühler 6 ist zwischen zwei Eindrückstegen 11 des Stößelkopfes 5 gelagert.

Zum Anschließen einer Kabelader 35 an einen in einer Anschlußleiste 36 angeordneten Schneidklemmkontakt 7 wird zuerst die Kabelader 35 über den Kontaktschlitz 38 des Schneidklemmkontaktes 7 eingelegt. Zum Eindrücken der Kabelader 35 wird von Hand auf den Handgriff 16 eine entsprechende Kraft in Richtung des Pfeiles 39 gegen die Kraft der im Handgriff 16 angeordneten beiden Druckfedern 40,41 ausgeübt, bis die Kabelader 35 in den Kontaktschlitz 38 eingedrückt ist. Zum Abschneiden des überstehenden Endes der Kabelader 35 ist der Abschneider 29 am Stößelkopf 5 angeordnet. Der Abschneidevorgang wird durch die Längsverschiebung des Stößels 2 im Handgriff 16 bewirkt, da der im Handgriff 16 befestigte Stift 42 in einen Längsschlitz 43 eines Scherenschenkels 4 des Abschneiders 29 hineingleitet und dabei den beweglichen Scherenschenkel 4 verschwenkt.

Hierdurch schneidet der Abschneider 29 das überstehende Ende der Kabelader 35 in einem vorgegebenen Abstand zu der Klemmverbindung ab.

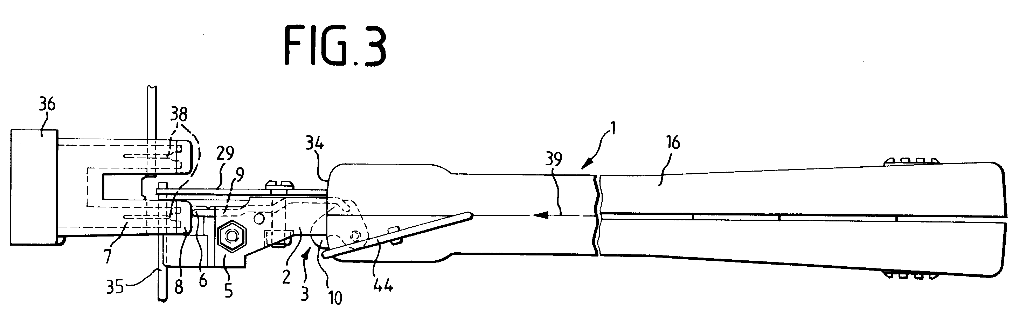

Wie insbesondere die Fig. 3 zeigt, kommt es aber erst dann zu einer Längsbewegung des Stößels 2 im Handgriff 16, wenn das Rastgesperre 3 um die Achse 26 gedreht wird und somit die an der Stirnseite 32 des Handgriffes 16 anliegende Klinke 10 entriegelt ist. Die Drehung der Klinke 10 erfolgt durch den Fühler 6 über die Fühlerstange 9. Der Fühler 6 wird erst dann betätigt, wenn gewährleistet ist, daß die anzuschließende Kabelader 35 im Kontaktschlitz 38 ihre Endlage erreicht hat. Erst dann werden der Fühler 6 und somit die Fühlerstange 9 durch Auflage am Bauteil 8 der Anschlußleiste 36 entgegen der Pfeilrichtung 39 bewegt. Durch Ausklinken der Klinke 10 des Rastgesperres 3 wird die Längsverschiebung des Stößels 2 freigegeben und der Abschneidevorgang eingeleitet.

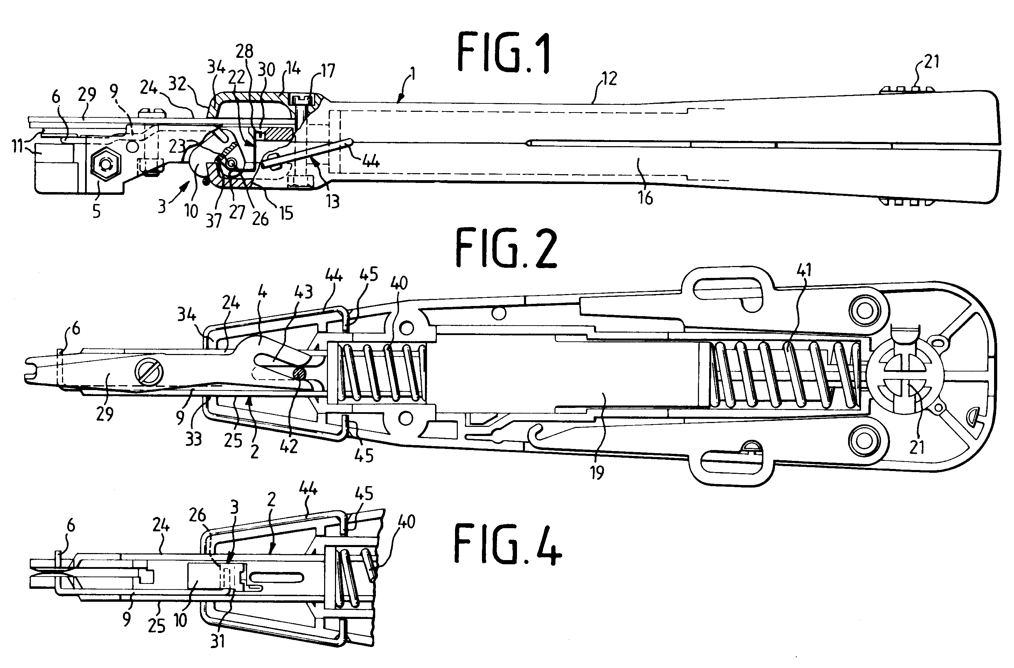

In Fällen von Mehrfachbeschaltungen, wenn zum Beispiel zwei Kabeladern an einem Schneidklemmkontakt angeschlossen werden sollen, kann die Klinke 10 des Rastgesperres 3 auch ohne die Betätigung des Fühlers 6 ausgeklinkt werden. Hierzu ist, wie in Fig. 2 dargestellt, außen an den Gehäuseschalen 14,15 des Handgriffes 16 ein U-förmiger Drahtbügel 44 als Entriegelungsvorrichtung 13 an seinen beiden Schenkelenden 45 befestigt. Durch Schwenken des Drahtbügels 44 per Hand drückt der mittlere Teil des Drahtbügels 44 gegen die Klinke 10 und dreht somit die Klinke 10 des Rastgesperres 3 nach innen, die Längsverschiebung des Stößels 2 wird somit freigegeben.

Soll die Längsverschiebung des Stößels 2 jedoch weder durch den Fühler 6 noch durch die Entriegelungsvorrichtung 13 freigegeben werden, so wird der Stößel 2 durch Drehen des Drehknopfes 21 festgelegt. Die Funktion des Drehknopfes ist ausführlich in der EP-PS 0040307 beschrieben.

**BEZUGSZEICHENLISTE**

Werkzeug zum Anschließen von Kabeladern

| 1 | Werkzeug |
|---|---|
| 2 | Stößel |
| 3 | Rastgesperre |
| 4 | Scherenschenkel |
| 5 | Stößelkopf |
| 6 | Fühler |
| 7 | Schneidklemmkontakt |
| 8 | Bauteile |
| 9 | Fühlerstange |
| 10 | Klinke |
| 11 | Eindrücksteg |
| 12 | Werkzeuggehäuse |
| 13 | Entriegelungsvorrichtung |
| 14,15 | Gehäuseschalen |
| 16 | Handgriff |
| 17 | Schrauben |
| 18 | Ansatz |
| 19 | Schieber |
| 20 | Druckfedern |
| 21 | Drehknopf |
| 22 | Schenkelfeder |
| 23 | Bohrung |
| 24,25 | Seitenwände |
| 26 | Achse |
| 27,28 | Schenkel |
| 29 | Abschneider |
| 30 | Querwand |
| 31 | Seitenwand |
| 32 | Stirnseite |
| 33 | Öffnung |
| 34 | Stirnwand |
| 35 | Kabelader |
| 36 | Anschlußleiste |
| 37 | Bohrung |
| 38 | Kontaktschlitz |
| 39 | Pfeil |
| 40,41 | Druckfeder |
| 42 | Stift |
| 43 | Längsschlitz |

44 Drahtbügel
45 Schenkelenden

## Patentansprüche

1. Werkzeug zum Anschließen von Kabeladern, insbesondere von Fernmeldekabeln, an Schneidklemmkontakten mit einem im Werkzeuggehäuse längs verschiebbaren Stößel und mit einem am Stößelkopf angeordneten Abschneider für die Kabeladern, wobei die Längsverschiebung des Stößels zum Auslösen des Abschneidens dient,
   **dadurch gekennzeichnet,**
   daß am Stößel (2) ein Rastgesperre (3) angeordnet ist, das die Längsverschiebung des Stößels (2) gegenüber dem Gehäuse (12) sperrt, und daß am Stößelkopf (5) ein mit dem Rastgesperre (3) verbundener Fühler (6) angeordnet ist, der bei Betätigung durch den Schneidklemmkontakt (7) bzw. ein diesen umgebendes Bauteil (8) das Rastgesperre (3) freigibt.

2. Werkzeug nach Anspruch 1,
   **dadurch gekennzeichnet,**
   daß der Fühler (6) über eine Fühlerstange (9) auf eine federbelastete Klinke (10) des Rastgesperres (3) einwirkt.

3. Werkzeug nach Anspruch 1,
   **dadurch gekennzeichnet,**
   daß der Fühler (6) zwischen zwei Eindrückstegen (11) des Stößelkopfes (5) gelagert ist.

4. Werkzeug nach Anspruch 1,
   **dadurch gekennzeichnet,**
   daß am Werkzeuggehäuse (12) eine Entriegelungsvorrichtung (13) zur Entriegelung der federbelasteten Klinke (10) des Rastgesperres (3) angeordnet ist.

## Claims

1. A tool for connecting a cable core, in particular of communication cables, to cutting and clamping contacts, comprising a plunger being longitudinally displaceable in the tool housing, and a cutting device for the cable core, said cutting device being disposed at the plunger head, and the longitudinal displacement of the plunger serving for tripping the cutting process,
   characterised by that at the plunger (2), a locking device (3) is arranged, said locking device (3) blocking the longitudinal displacement of the plunger (2) relative to the housing (12), and that at the plunger head (5), a tracer (6) is arranged, said tracer (6) releasing the locking device (3) when actuated by the cutting and clamping contact (7) or by the component (8) surrounding the latter, resp.

2. A tool according to claim 1,
   characterised by that the tracer (6) acts, over a tracer bar (9), on a spring-loaded latch (10) of the locking device (3).

3. A tool according to claim 1,
   characterized by that the tracer (6) is supported between two press-in webs (11) of the plunger head (5).

4. A tool according to claim 1,
   characterised by that at the tool housing (12), an unlocking device (13) for unlocking the spring-loaded latch (10) of the locking device (3) is provided.

## Revendications

1. Outil pour le raccordement d'âmes de câble, essentiellement de câbles de télécommunication, sur des contacts par déplacement d'isolation, avec un coulisseau déplaçable longitudinalement dans le boîtier de l'outil et un coupe-fil fixé sur la tête du coulisseau pour les âmes de câble, le déplacement longitudinal du coulisseau servant au déclenchement de la découpe,
   **caractérisé en ce que**
   sur le coulisseau (2) est disposé un dispositif d'arrêt (3) qui bloque le déplacement longitudinal du coulisseau (2) par rapport au boitier (12) et que sur la tête du coulisseau (5) est disposé un palpeur (6) relié au dispositif d'arrêt (3) et qui libère le dispositif d'arrêt (3) par actionnement par le contact par déplacement d'isolation (7) ou un composant (8) entourant ce contact.

2. Outil selon la revendication 1,
   **caractérisé en ce que**
   le palpeur (6) agit à travers une tige (9) sur un cliquet (10) chargé par ressort du dispositif d'arrêt (3).

3. Outil selon la revendication 1,
   **caractérisé en ce que**
   le palpeur (6) est logé entre deux étançons d'introduction (11) de la tête du coulisseau (5)

4. Outil selon la revenducation 1,
   **caractérisé en ce que**
   un dispositif de déverrouillage (13) pour le déblquage du cliquet chargé par ressort (10) du dispositif d'arrêt (3) est disposé sur le boitier (12) de l'outil.

FIG.1

FIG.2

FIG.4

FIG.3